# EUROPÄISCHE PATENTSCHRIFT

(11) **EP 3 395 130 B1**
(45) Veröffentlichungstag und Bekanntmachung des Hinweises auf die Patenterteilung: **10.11.2021**
(21) Anmeldenummer: 16757174.4
(22) Anmeldetag: 10.08.2016
(51) Int. Cl.: H05K 3/12, G01J 5/02, H01L 37/02, H05K 3/46, G01J 5/34, H05K 1/05, H05K 3/28

(54) **METALLBAND UND COIL-COATING-VERFAHREN**
METAL STRIP AND COIL COATING METHOD
BANDE METALLIQUE ET PROCEDE D'ENDUCTION DE BANDES EN CONTINU

(30) Priorität: 23.12.2015 EP 15202647
(43) Veröffentlichungstag der Anmeldung: 31.10.2018
(73) Patentinhaber: voestalpine Stahl GmbH, 4020 Linz (AT)
(72) Erfinder: SCHATZL-LINDER, Michaela, 4611 Buchkirchen (AT); JAKOBY, Bernhard, 4040 Linz (AT); HILBER, Wolfgang, 4293 Gutau (AT); SELL, Johannes, 4030 Linz (AT); ENSER, Herbert, Linz 4040 (AT); BAUER, Siegfried, Linz 4040 (AT); KRAUSE, Markus, 4202 Hellmonsödt (AT)
(74) Vertreter: Jell, Friedrich
(86) Internationale Anmeldenummer: PCT/EP2016/069086
(87) Internationale Veröffentlichungsnummer: WO 2017/108213

(56) Entgegenhaltungen:
- EP-A1- 1 798 732
- EP-A1- 2 605 280
- CN-B- 102 003 998
- US-A- 4 060 729
- US-A- 4 379 971
- US-A- 6 049 080
- US-A1- 2006 176 350
- US-A1- 2007 215 039
- US-A1- 2007 283 769
- US-A1- 2009 039 341
- US-A1- 2009 236 979
- US-A1- 2010 180 701
- US-A1- 2011 004 102
- US-A1- 2013 328 026
- US-A1- 2015 339 001

## Beschreibung

### Technisches Gebiet

Die Erfindung betrifft ein Metallband und ein Coil-Coating-Verfahren zur mehrschichtigen Beschichtung eines endlosen Metallbands, bei welchem auf eine Flachseite des Metallbands mithilfe eines Walzenauftrags eine aushärtbare polymere Grundierung zur Ausbildung einer elektrisch isolierenden Grundierungsschicht und auf diese Grundierungsschicht mithilfe eines Walzenauftrags ein aushärtbarer polymerer Lack zur Ausbildung einer elektrisch isolierenden Lackschicht aufgebracht und gehärtet werden, wobei zwischen Grundierungsschicht und Lackschicht wenigstens eine elektrische Leiterschicht zumindest bereichsweise aufgedruckt wird.

### Stand der Technik

Zur elektrischen Funktionalisierung eines Metallbands im Coil-Coating-Verfahren ist es aus der EP2605280A1 bekannt, zwischen einer elektrisch isolierenden Grundierung auf dem Metallband und einer Decklackschicht auf der Grundierung zwei endlose elektrische Leiterbahnen sowie damit kontaktierte photovoltaische Zellen vorzusehen. Grundierung und Decklacksicht werden mithilfe eines Walzenauftrags aufgetragen - wobei die elektrischen Leiterbahnen sowie die photovoltaischen Zellen aufgedruckt auch werden können. Allerdings zeigt kein Stand der Technik, ein Metallband im Coil-Coating-Verfahren mit elektrisch aktiven Elementen zu funktionalisieren.

Ausgehend vom eingangs geschilderten Stand der Technik hat sich die Erfindung daher die Aufgabe gestellt, ein Coil-Coating-Verfahren zu schaffen, das ein Metallband reproduzierbar mit elektrisch aktiven Elementen versehen kann.

### Darstellung der Erfindung

Die Erfindung löst die gestellte Aufgabe hinsichtlich des Coil-Coating-Verfahrens dadurch, dass an die elektrische Leiterschicht zumindest bereichsweise eine elektrisch polarisierbare Schicht aufgebracht wird, wobei elektrische Leiterschicht und elektrisch polarisierbare Schicht nass-in-nass aufgebracht werden.

Wird an die elektrische Leiterschicht zumindest bereichsweise eine elektrisch polarisierbare Schicht aufgebracht, so kann das Metallband bereits mit dem Coil-Coating Verfahren hinsichtlich einer elektrischen Funktionalität vorbereitet werden. Überraschend hat sich hierbei jedoch herausgestellt, dass solch ein Aufbringen einer elektrisch polarisierbaren Schicht im Coil-Coating Verfahren einer besonderen Sorgfalt bedarf, um beispielsweise zur späteren Polarisierung der aufgebrachten elektrisch polarisierbaren Schicht eine hohe Durchschlagsfestigkeit gewährleisten zu können.

Um dies zu ermöglichen, schlägt die Erfindung zusätzlich vor, dass elektrische Leiterschicht und elektrisch polarisierbare Schicht nass-in-nass aufgebracht werden. Damit kann sichergestellt werden, dass die elektrisch polarisierbare Schicht an einer unausgehärteten elektrischen Leiterschicht vorgesehen wird, wodurch beispielsweise scharfe Konturen im Randbereich der Leiterschichten geglättet werden können. Dies kann nicht nur der Homogenität der Schichtdicke der aufgebrachten elektrisch polarisierbaren Schicht förderlich sein, sondern auch Singularitäten bei der Polarisierung der elektrisch polarisierbaren Schicht vermeiden. Das erfindungsgemäße Verfahren kann daher eine vergleichsweise hohe Reproduzierbarkeit aufweisen und eben auf Grundlage des Nass-in-nass-Aufbringens ein Metallband auch für die Nutzung einer elektrischen Polarisation zuverlässig vorbereiten.

Zudem kann durch das Nass-in-nass-Aufbringen eventuell ein teilweises Ineinanderverfließen der elektrisch polarisierbaren Schicht mit der Leiterschicht erleichtert werden - was deren zuverlässige und homogene stoffschlüssige Verbindung sicherstellen kann. Beispielsweise kann sich eine Übergangszone, insbesondere in der Art einer Mischschicht als Grenzschicht, ausbilden - welche sich gerade bei einer metallischen Leiterschicht in einer besonders haftfesten Interphase zwischen Leiterschicht und elektrisch polarisierbarer Schicht ausdrückt. Solch eine Übergangszone kann beispielsweise innere Spannungen im Schichtaufbau reduzieren.

In jenen Fällen, in welchen die nass-in-nass aufgebrachten Schichten begrenzt oder nicht miteinander mischbar sind, kann weiterhin mit einer Optimierung der Grenzschicht oder bei nicht mischbaren Bedingungen der Grenzfläche zwischen den nass-in-nass aufgebrachten Schichten gerechnet werden. Beispielsweise, indem Erhebungen an der Grenzschicht/Grenzfläche geebnet werden. Im Allgemeinen wird erwähnt, dass sich durch ein Nass-in-nass-Aufbringen dieser beiden Schichten zwischen diesen eine geglättete Grenzschicht oder Grenzfläche ausbilden kann. All diese Vorteile können sich zudem als die Reproduzierbarkeit des Verfahrens unterstützende Faktoren auszeichnen.

Im Allgemeinen wird erwähnt, dass das Metallband ein Stahlband, Aluminiumband bzw. aus deren Legierungen bestehen kann. Dieses Metallband kann unbeschichtet oder - z. B. organisch/metallisch, beispielsweise verzinkt oder legierungsverzinkt - beschichtet, sein. Auch kann dieses Metallband ein verzinktes oder legierungsverzinktes Stahlband sein. Im Allgemeinen wird weiter erwähnt, dass Leiterschicht und elektrisch polarisierbare Schicht derart nass-in-nass aufgebracht werden können, dass damit ein Verfließen der beiden Schichten zumindest an ihren Grenzschichten zugelassen wird.

Das erfindungsgemäße Verfahren kann sich besonders zur Funktionalisierung des Metallbands mit Sensoren auszeichnen, in der elektrisch polarisierbaren Schicht durch eine Polarisierung eine piezoelektrische und/oder pyroelektrische Eigenschaft ausgebildet wird. Damit können nämlich reproduzierbar Sensoren für berührungslose Schaltelemente wie beispielsweise Taster, oder Infrarotsensoren direkt am Metallband vorgesehen werden.

Wird als elektrisch polarisierbare Schicht eine PVDF (Polyvinylidenfluorid)-Schicht aufgebracht, so kann eine Schicht mit ferroelektrischen - also piezo- und pyroelektrischen - Eigenschaften auf verfahrenstechnisch besonders einfache Weise hergestellt werden. Als PVDF (Polyvinylidenfluorid)-Schicht kann beispielsweise P(VDF-TrFE) (Vinylidenfluorid-Trifluoroethlyen Co-Polymer) zum Ausbilden solche einer ferroelektrischen Schicht auszeichnen. Solche PVDF-basierten Polymerschichten zeigen bei der erfindungsgemäßen Lösung ausgezeichnete pyroelektrische und piezoelektrische Eigenschaften. Funktionale Schichten hoher Güte und Qualität können so geschaffen werden.

Wird als elektrische Leiterschicht PEDOT:PSS aufgebracht, kann dies die Funktionalisierung des Metallbands weiter erleichtern und damit die Reproduzierbarkeit des Coil-Coating-Verfahrens weiter erhöhen.

Die elektrische Polarisierbarkeit der elektrisch polarisierbaren Schicht kann zudem erheblich verbessert werden, wenn die elektrische Leiterschicht angetrocknet wird, bevor die elektrisch polarisierbare Schicht an dieser elektrischen Leiterschicht nass-in-nass aufgebracht wird. Dadurch kann eine eventuelle tiefgehende Vermischung der Leiterschicht mit der elektrisch polarisierbaren Schicht vermieden werden, was die funktionellen Eigenschaften der Schichten negativ beeinflussen könnte. Eine vorteilhaft scharf abgegrenzte Grenzschicht kann so sichergestellt werden.

Inneren Spannungen in den Schichten können verfahrenstechnisch weiter reduziert werden, wenn die elektrische Leiterschicht und die elektrisch polarisierbare Schicht gleichzeitig gehärtet werden. Bevorzugt erfolgt dies in einem Arbeitsgang, um beispielsweise durch kontinuierliche Prozessparameter die innere Spannungsfreiheit der Schichten weiter zu verbessern. Des Weiteren kann dies die Effizienz des Verfahrens deutlich erhöhen, weil auf diese Weise eine fertige Beschichtung des Metallbands in einem Durchlauf ermöglicht wird.

Wird an die elektrisch polarisierbare Schicht eine weitere, zweite elektrische Leiterschicht aufgedruckt, so kann auf verfahrenstechnisch einfache Weise ein vollwertiges elektrisch aktives Element - beispielsweise ein pyroelektrischer Sensor oder ein piezoelektrisches Element - mit Grund- und Deckelektrode geschaffen werden. Durch das Aufdrucken kann zudem unkompliziert und somit kostengünstig jede beliebige Lage und/oder Form der Elektroden, welche durch die Leiterschichten ausgebildet werden, hergestellt werden. Im Allgemeinen ist etwa vorstellbar, dass die erste elektrische Leiterschicht zusammen mit der zweiten elektrischen Leiterschicht eine Sensormatrix ausbildet.

Um die elektrisch polarisierbare Schicht auf vorteilhafte Weise gleichmäßig zu polarisieren, werden die erste und zweite Leiterschicht elektrisch kontaktiert und damit die elektrisch polarisierbare Schicht polarisiert. Vorteilhaft werden hierzu die Leiterschichten dabei mit den Elektroden einer gängigen Polarisierungseinrichtung - etwa nach dem Sawyer-Tower-Verfahren - kontaktiert. So kann etwa in einem Verfahrensschritt an allen, über die erste und zweite Leiterschicht ausgebildeten elektrisch aktiven Elementen eine Polarisierungsspannung angelegt werden - wodurch in weiterer Folge alle elektrisch aktiven Elemente gleichartig polarisierbar sind.

Im Allgemeinen wird festgehalten, dass diese Polarisierung gezielt bei einer erhöhten Umgebungstemperatur erfolgen kann, um das erfindungsgemäße Verfahren zu beschleunigen, aber auch - wie sich überraschend herausgestellt hat - um die Qualität der Polarisierung zu verbessern.

Im Allgemeinen wird weiter festgehalten, dass das Polarisieren der elektrisch polarisierbaren Schicht verfahrenstechnisch vergleichsweise leicht durchgeführt werden kann, wenn vor dem weiteren Beschichten der zweiten Leiterschicht die beiden Leiterschichten elektrisch kontaktiert werden um den Kontaktwiderstand nicht zu beeinflussen.

Eine elektrische Leiterschicht kann verfahrenstechnisch rasch und kostengünstig mithilfe eines Rolle-zu-Rolle-Verfahrens ("Roll-to-Roll") aufgedruckt werden. Dieses Rolle-zu-Rolle-Verfahren kann unter anderem auch in jenen Fällen nützlich sein, in welchen andere elektrische Bauelemente auf der Grundierungsschicht vorzusehen sind. Beispielsweise kann sich in diesem Zusammenhang ein das Aufdrucken mittels Walzenauftrag auszeichnen, um so die Effektivität dieses Coil-Coating-Verfahrens zu erhöhen.

Vorzugsweise wird die Leiterschicht als Rapport aufgedruckt, um die Reproduzierbarkeit des Verfahrens durch ein sich wiederholendes Muster zu erhöhen.

Wird auf der Flachseite des Metallbands eine Konversionsschicht erzeugt, so kann die Korrosionsfestigkeit des Metallbands erheblich erhöht werden. Wird zudem an dieser Konversionsschicht die aushärtbare polymere Grundierung angebracht, so kann die Haftfestigkeit zwischen der Grundierung und dem Stahlband weiter erhöht. Durch diese beiden Vorteile - und zwar im Speziellen durch deren Kombination - kann das erfindungsgemäße Verfahren in seiner Reproduzierbarkeit verbessert werden.

Haftfestigkeit und Druckqualität der Leiterschicht können verbessert werden, wenn die elektrische Leiterschicht an der vorgehärteten, insbesondere zumindest bis über den Gelpunkt vorgehärteten, Grundierungsschicht aufgedruckt wird. Durch Vermeidung einer vollständigen Aushärtung kann eine verbesserte Anbindung an angrenzende Schichten ermöglicht werden. In diesem Zusammenhang hat sich ein Vorhärten der Grundierung zumindest bis über ihrem Gelpunkt, d.h. fast vollständig vernetzt, ausgezeichnet.

Die mechanische und auch die chemische Beständigkeit der Beschichtung können erhöht werden, indem sowohl die Grundierung als auch der Lack chemisch vernetzt werden.

Es ist außerdem die Aufgabe der Erfindung ein mit Hilfe eines Coil-Coating Verfahrens beschichtetes Metallband in seiner Funktionalität zu erhöhen, ohne dabei aber die Standfestigkeit der Beschichtung am Metallband zu gefährden oder die Herstellungskosten zu erhöhen.

Die Erfindung löst die gestellte Aufgabe dadurch, dass das Metallband eine elektrisch polarisierte Schicht aufweist, die an die Leiterschicht über eine sich durch ein Nass-in-nass-Aufbringen dieser beiden Schichten ausbildenden Grenzschicht oder Grenzfläche anschließt.

Weist das Metallband eine elektrisch polarisierte Schicht auf, kann das Metallband in Bezug auf die Nutzung technischer Effekte der polarisierten Schicht in seiner Funktionalität erhöht werden. Um dennoch mit keiner Einschränkung in der Standfestigkeit des Metallbands - beispielsweise infolge eines Aufwickelns zu einem Bund - rechnen zu müssen, kann vorgesehen sein, dass die elektrisch polarisierte Schicht an die Leiterschicht über eine sich durch ein Nass-in-nass-Aufbringen dieser beiden Schichten ausbildenden Grenzschicht oder Grenzfläche anschließt. Im Allgemeinen wird erwähnt, dass diese Grenzschicht (bei miteinander mischbaren Schichten) oder diese Grenzfläche (bei miteinander nicht mischbaren Schichten) durch den Nass-in-nass-Auftrag beispielsweise geglättet werden. Damit können Unebenheiten und lokale Spannungsspitzen reduziert werden, was zu einer abgerundetem Kontur an der Leiterschicht und die elektrische Kurzschlussfestigkeit der Beschichtung deutlich erhöhen kann. Die Standfestigkeit der Funktionalisierung des Metallbands kann damit erheblich verbessert werden.

Weist das Metallband eine zweite, auf der elektrisch polarisierten Schicht vorgesehene, elektrische Leiterschicht auf, kann die elektrisch polarisierte Schicht auf konstruktiv einfache Weise elektrisch angeschlossen werden.

Bilden die erste und zweite Leiterschicht und die elektrisch polarisierte Schicht mindestens einen Aktor und/oder einen Sensor am Metallband aus, so kann das erfindungsgemäße Metallband sowohl als aktives als auch passives funktionales Element ausgebildet sein. Nicht zuletzt können dadurch mehrere Aktoren und/oder Sensoren abwechselnd nebeneinander angeordnet sein - und so etwa eine Sensor- und Aktormatrix ausbilden. Hierbei kann es vorteilhaft sein, wenn die erste und zweite Leiterschicht zusammen ein Leiterbahnnetz aufspannen. Beispielsweise ist vorstellbar, dass die erste Leiterschicht die Leiterbahnen für die Spaltenansteuerung und die zweite Leiterschicht die Leiterbahnen für die Zeilenansteuerung der Sensor- und Aktormatrix ausbilden.

Wirken Aktor und Sensor, miteinander elektrisch verbunden, zur Schwingungskompensation am Metallband zusammen, kann auf konstruktiv einfache Weise ein aktiver Schwingungskompensator geschaffen werden. Handelt es sich bei den Sensoren und Aktoren um Piezosensoren bzw. -aktoren, so kann beispielsweise eine Sensor- und Aktormatrix zur aktiven Reduzierung des Schallpegels geschaffen werden. Dabei können die elektrischen Signale der Schallwellen von den Piezosensoren aufgezeichnet werden und an die benachbarten Piezoaktoren zur Schalldämpfung mit eventuell veränderten Signalen (etwa phasenverschoben) wieder zugeführt werden.

Ist die elektrisch polarisierte Schicht pyroelektrisch und ist der Sensor als Infrarotsensor ausgebildet, kann auf konstruktiv einfache Weise ein Wärmedetektor oder berührungsloser Sensor geschaffen werden. Ein solcher berührungsloser Infrarotsensor kann sich beispielsweise als berührungsloser Taster in hygienischen Umgebungen eignen.

Im Allgemeinen wird zudem festgehalten, dass die Steuerungselektronik für die Aktoren bzw. Sensoren in der elektrisch polarisierten Schicht bzw. in den Leiterschichten integriert bzw. eingebettet werden kann.

Vorzugsweise weisen elektrische Leiterschicht PEDOT:PSS und die elektrisch polarisierbare Schicht PVDF, insbesondere P[VDF-TrFE], auf, um eine standfeste Funktionalisierung des Endlosbands sicherstellen zu können.

### Kurze Beschreibung der Zeichnungen

In den Figuren ist das erfindungsgemäße Verfahren in Form einer Ausführungsvariante dargestellt. Es zeigen
- Fig. 1: eine schematische Ansicht auf eine Vorrichtung für ein Coil-Coating-Verfahren,
- Fig. 2: eine Schnittansicht durch ein gemäß dem Verfahren nach Fig. 1 beschichte-tes Metallband nach einem ersten Ausführungsbeispiel,
- Fig. 3: eine Detailansicht auf Fig. 2 und
- Fig. 4: ein beschichtetes Metallband mit piezoelektrischen Sensoren und Aktoren und
- Fig. 5: ein beschichtetes Metallband mit pyroelektrischen Infrarotsensoren.

### Wege zur Ausführung der Erfindung

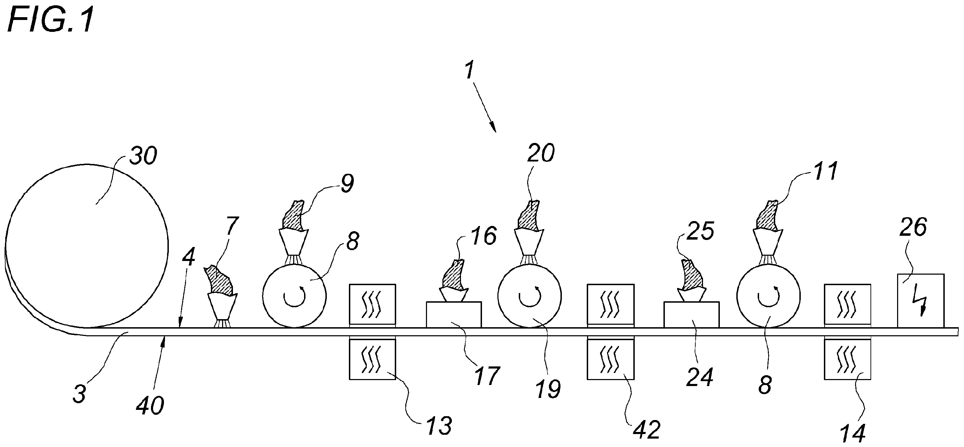

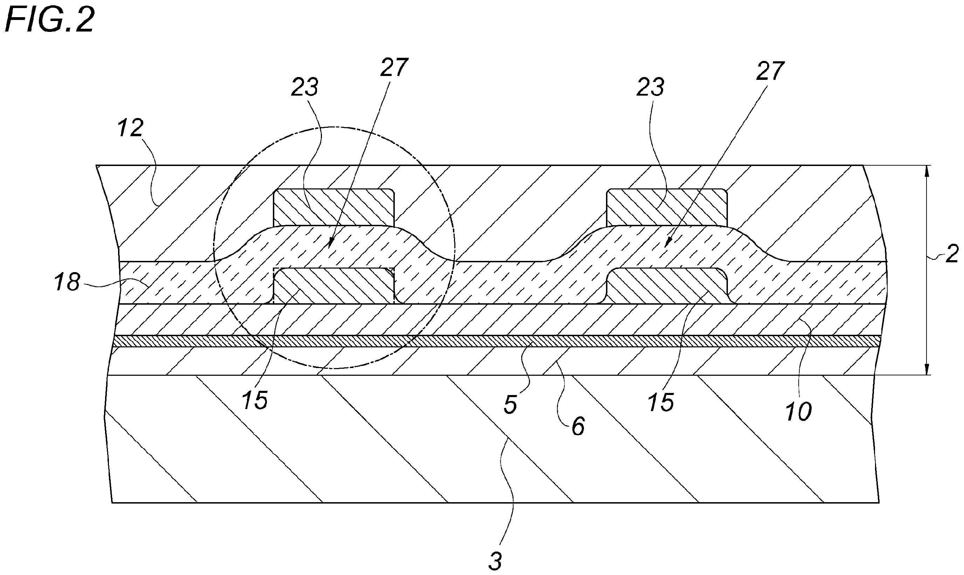

Gemäß Fig. 1 wird eine Vorrichtung 1 zur Durchführung des erfindungsgemäßen Coil-Coating-Verfahrens gezeigt, bei welchem ein endloses Metallband 3, nämlich in diesem Fall Stahlband, von einem Coil 30 abgewickelt und im Banddurchlauf kontinuierlich mit einer mehrschichtigen Beschichtung 2 (siehe hierzu Fig. 2) versehen wird.

Mithilfe einer Walze 8 eines nicht dargestellten Coaters, wird auf eine Flachseite 4 des Metallbands 3 eine aushärtbare polymere Grundierung 9 bzw. Primer aufgebracht, um auf dieser Flachseite 4 eine elektrisch isolierende Grundierungsschicht 10 zu erzeugen. Die Grundierung 9 kann beispielsweise eine Polyesterbasis aufweisen. Damit wird bekanntermaßen die Haftfestigkeit am und/oder der Korrosionsschutz des Metallbands 3 erhöht.

Auf die Grundierungsschicht 10 auf der Flachseite 4 des Metallbands 3 wird in weiterer Folge ein aushärtbarer, aushärtbarer polymerer und elektrisch isolierender Lack 11, der beispielsweise ebenso eine Polyesterbasis aufweist, zur Ausbildung einer elektrisch isolierenden Lackschicht 12 aufgebracht. Dieses Aufbringen erfolgt - gleichwie beim Grundierungsauftrag dargestellt - mithilfe einer Walze 8 eines nicht näher dargestellten Coaters. Die aufgetragene Grundierung 9 und der aufgetragene Lack 11 werden jeweils durch einen Trockner 13, 14 gehärtet bzw. durch chemisches Vernetzen gehärtet. Es hat sich gezeigt, dass die elektrische Kurzschlussfestigkeit der Beschichtung 2 erhöht werden kann, indem die aufgebrachte Grundierung 9 zur Ausbildung der Grundierungsschicht 10 zumindest bis über ihren Gelpunkt vorgehärtet bzw. vorgetrocknet wird, bevor die Leiterschichten 15 aufgebracht werden.

Grundierungsschicht 10 und Lackschicht 12 sind jeweils elektrisch isolierend ausgebildet, um das Metallband 3 mit einer gewünschten elektrischen Funktionalität versehen zu können.

Solch eine elektrische Funktionalität wird geschaffen, indem vor dem Aufbringen des Lacks 11 mithilfe eines Rolle-zu-Rolle-Verfahrens mehrere elektrisch leitende Leiterschichten 15 bereichsweise aufgedruckt werden. Dieses Rolle-zu-Rolle-Verfahren erfolgt vorteilhaft mithilfe eines Druckers 17 (Digitaldruck, Siebdruck, Tiefdruck etc.). Verfahrenstechnisch einfach kann ein solches Drucken über einen sich wiederholenden Rapport erfolgen.

Als Paste bzw. Tinte zur Ausbildung der Leiterschichten 15 wird ein elektrisch leitfähiges Polymer 16, beispielsweise PSS (Polystyrolsulfonat), verwendet. Solch eine Paste bzw. Tinte kann stattdessen allerdings auch eine metallische Basis - etwa Silber, Kupfer oder Gold -, eine organische Basis - etwa PEDOT (Poly-3,4-ethylendioxythiophen) - oder eine Graphenbasis aufweisen. Ebenso sind hierfür andere Stoffe, etwa Carbon oder Graphit denkbar. Tinten und/oder Pasten mit metallischer Basis können sich durch eine besonders hohe Leitfähigkeit auszeichnen, wohingegen Tinten und/oder Pasten mit organischer Basis zumeist eine erhöhte Korrosionsbeständigkeit bieten können. Als Leiterschichten 15 kann sich vorzugsweise PEDOT:PSS auszeichnen, das beispielsweise als wässrige und/oder Isopropanol-basierte Dispersion aufgedruckt wird.

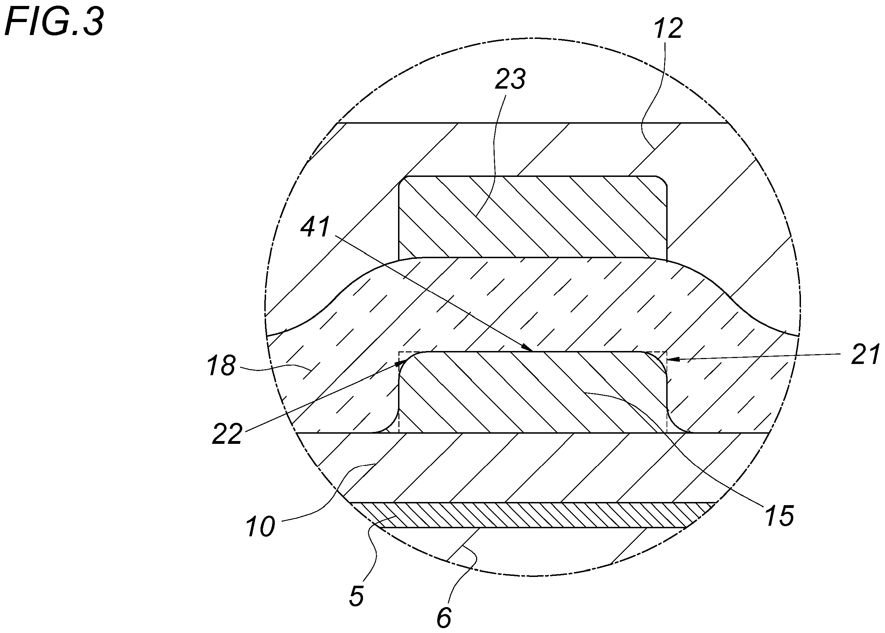

Nachfolgend wird auf diese aufgedruckten Leiterschichten 15 ein aushärtbarer polymerer Lack 11 vorgesehen. Ein kompakter Schichtverbund bzw. eine kompakte Beschichtung 2 mit zumindest abschnittsweise gekapselten Leiterschichten 15 ist damit gegeben - wie dies nach den Figuren 2 und 3 dargestellt ist.

Vor dem Vorsehen des Lacks 11 wird erfindungsgemäß an die elektrischen Leiterschichten 15 eine elektrisch polarisierbare Schicht 18 mithilfe eines Coaters 19 vorgesehen. Das dabei verwendete elektrisch polarisierbare Polymer 20 ist insbesondere ferroelektrisch, also pyro- und piezoelektrisch, wobei sich eine Basis von Polyvinylidenfluorids (PVDF) oder Vinylidenfluorid-Trifluoroethylen Co-Polymers (P[VDF-TrFE]) als besonders vorteilhaft herausstellt. Das elektrisch polarisierbare Polymer 20 wird dabei auf die noch nassen elektrischen Leiterschichten 15 aufgedruckt - was daher teilweise zu einer Formveränderung der Leiterbahnkontur bzw. zu einem Verfließen des elektrisch leitfähigen Polymers 16 der Leiterschichten 15 und des ferroelektrischen Polymers 20 der elektrisch polarisierbaren Schicht 18 führt. Auf diese Weise (nass-in-nass Auftrag der Schichten 15, 18) werden scharfkantige Strukturabgrenzungen im Übergang zwischen Leiterschicht 15 und elektrisch polarisierbarer Schicht 18 vermieden - dieses Merkmal wird nach den Figuren 2 und 3 dargestellt.

Insbesondere der Fig. 3 kann entnommen werden, dass die Kontur 21 der Leiterschichten 15 vor dem Aufbringen der elektrisch polarisierbaren Schicht 18 einen - in Strichlinien dargestellten - scharfkantigen Verlauf zeigt, während die Kontur 22 der Leiterschichten 15 nach dem Aufbringen der elektrisch polarisierbaren Schicht 18 deutlich abgerundeter ist.

Durch ein Nass-in-nass-Aufbringen dieser beiden Schichten 15, 18 kann sohin die Grenzschicht 41 bzw. die Grenzfläche 41 geglättet werden. Unebenheiten sowie ein scharfkantige Strukturabgrenzungen zwischen Leiterschicht 15 und elektrisch polarisierbarer Schicht 18 sind auf dieser Weise zu vermeiden. Die sich durch das Nass-in-nass Aufbringen ergebende Grenzschicht 41 bzw. die Grenzfläche 41 führt beispielsweise zu einer hohe Durchschlagsfestigkeit an der elektrischen Funktionalisierung der Beschichtung 2. Zudem erhöht dies die auch die Haftfestigkeit der Schichten und damit die Standfestigkeit des Metallbands 3.

Um diesen Konturverlauf 22 der Leiterschichten 15 besser steuern zu können, kann vorgesehen sein, die Leiterschichten 15 vor dem Aufbringen der elektrisch polarisierbaren Schicht 18 vorzutrocknen. Insbesondere vorteilhaft ist hierbei, die Leiterschichten 15 bis vor ihren Gelpunkt des Polymers 16 anzutrocknen, um bei eventuell mischbaren Schichten ein tiefgehendes Vermischen dieser Schichten 15, 18 zu vermeiden.

Nach dem Aufbringen der elektrisch polarisierbaren Schicht 18, kann diese - und auch die elektrischen Leiterschichten 15 - gehärtet werden. Diese Trocknung bzw. Aushärtung kann gemeinsam in einem Arbeitsgang in einer Trocknungseinrichtung 42 erfolgen. Danach weist die elektrisch polarisierbare Schicht 18 vorzugsweise eine Trockenschichtdichte von mindestens 2µm auf.

Auf die elektrisch polarisierbare Schicht 18 wird eine weitere elektrisch Leiterschicht 23 mithilfe eines entsprechenden Druckers 24 aufgedruckt werden. Hierbei können sowohl dieselben Druckverfahren, als auch dieselben elektrisch leitfähigen Polymere 25 zum Einsatz kommen. Es ist jedoch ebenso vorstellbar, dass sich die elektrisch leitfähigen Polymere 16 und 25 in ihrer Zusammensetzung und in ihrem Grundmaterial voneinander unterscheiden.

Die beiden elektrischen Leiterschichten 15 und 23 werden danach mit einer elektrischen Polarisierungseinrichtung 26 kontaktiert, welche die elektrisch polarisierbare Schicht 18 zwischen den Leiterschichten 15 und 23 polarisiert. Nach erfolgter Polarisierung entstehen jeweils zwischen diesen zwei einander gegenüberliegenden Leiterschichten 15, 23 funktionsfähige elektrisch aktive Elemente 27. Die Polarisierung sollte vor dem Aufbringen der elektrisch isolierenden Lackschicht 12 erfolgen. Bei den elektrisch aktiven Elementen 27 kann es sich beispielsweise um piezoelektrische und/oder pyroelektrische Sensoren und/oder Aktoren handeln.

Vor dem Aufbringen der elektrisch isolierenden Grundierungsschicht 10 auf der oberen Flachseite 4 des Metallbands 3, wird zudem eine Konversionssicht 5 erzeugt - und zwar auf der metallischen Schutzschicht 6 des Metallbands 3. Diese Konversionsschicht 5 wird beispielsweise nach Fig. 1 durch ein Aufbringen, etwa durch Aufsprühen einer Lösung 7 realisiert.

In Fig. 1 nicht näher dargestellt ist die Beschichtung der anderen Flachseite 40 des Metallbands 3 im Coil-Coating-Verfahren, welche Flachseite 40 der Flachseite 4 gegenüberliegt. Diese kann ähnlich wie die Beschichtung der Flachseite 4 erfolgen - etwa, indem zunächst eine Konversionsschicht und auf diese Konversionsschicht ein Lack, beispielsweise ein Primer, aufgebracht wird - was allerdings nicht dargestellt ist. Damit kann die Flachseite 40 vor Flugrost, Weißrost bzw. vor anderen Umwelteinflüssen geschützt werden.

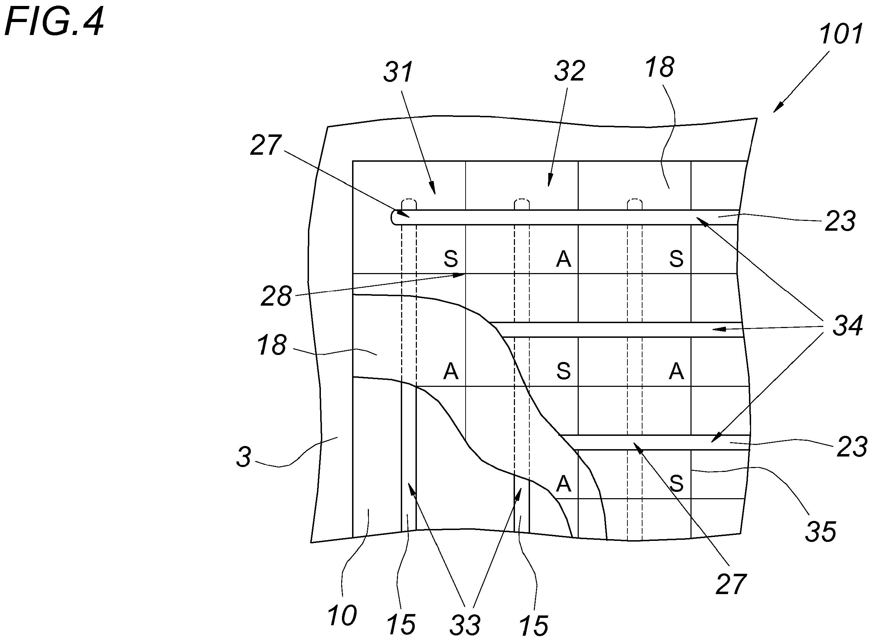

In Fig. 4 ist ein beschichtetes Metallband 101 gezeigt, auf welchem mit dem erfindungsgemäßen Coil-Coating-Verfahren 1 eine Sensor- und Aktormatrix 28 aufgebracht wurde. Dabei ist die elektrisch polarisierte Schicht 18 in einem vorgegebenen Muster, beispielsweise immer abwechselnd, als Piezosensoren 31 (mit S gekennzeichnet) und Piezoaktoren 32 (mit A gekennzeichnet) ausgebildet, welche in einer Sensor- und Aktormatrix 28 angeordnet sind. Die erste Leiterschicht 15 bildet dabei in einem konstanten Abstand parallel zueinander verlaufende Leiterbahnen 33 aus, die die Spaltenansteuerung der Sensor- und Aktormatrix 28 darstellen und (wie in Fig. 2 gezeigt) unterhalb der elektrisch polarisierten Schicht 18 angeordnet sind. Über der elektrisch polarisierten Schicht 18 bildet die zweite Leiterschicht 23 jeweils in konstantem Abstand parallel zueinander verlaufende Leiter 34 aus, welche die Zeilenansteuerung der Sensor- und Aktormatrix 28 darstellen. An den Kreuzungspunkten der Leiterbahnen 33 und 34 entstehen somit elektrisch aktive Elemente 27 in der elektrisch polarisierten Schicht 18. Die Piezosensoren 31 und Piezoaktoren 32 können zudem in der elektrisch polarisierten Schicht 18 physisch voneinander getrennt sein, etwa durch Freistellungen 35 wie in Fig. 4 angedeutet. Eine solche Matrix 28 kann etwa zur aktiven Schallpegelreduzierung verwendet werden, in dem der Schall über die Piezosensoren 31 gemessen und in ein elektrisches Signal umgewandelt wird und ein entsprechendes abgewandeltes Signal auf die Piezoaktoren 32 geschickt wird um den Schall auszulöschen (bspw. in dem sich eintreffender und erzeugter Schall destruktiv überlagern).

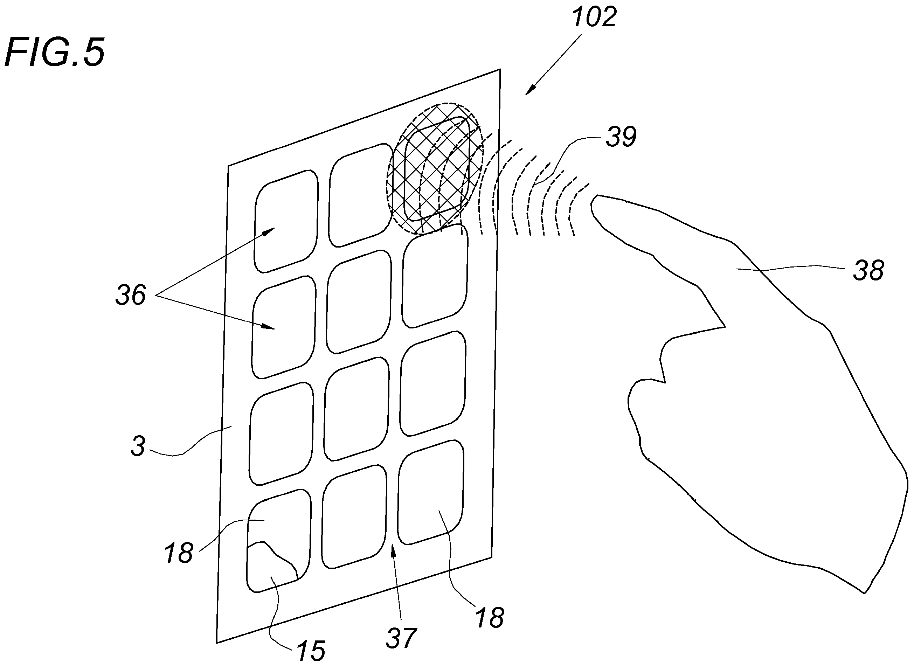

In Fig. 5 ist ein weiteres Ausführungsbeispiel für ein beschichtetes Metallband 102 gezeigt. Hierbei ist auf dem Metallband 3 eine pyroelektrische Schicht 18 vorgesehen, welche im Zusammenspiel mit der ersten und der zweiten elektrischen Leiterschicht 15, 23 Infrarotsensoren 36 ausbildet. Die Infrarotsensoren 36 können dabei eine Sensormatrix 37 formen, um etwa ein Bedienfeld am beschichteten Metallband 102 zu schaffen. Die von einem Objekt 38 ausgehende Infrarotstrahlung 39 trifft auf einem Sensor 36 ein und wird dabei in ein elektrisches Signal umgewandelt, welches etwa von einer zugehörigen Elektronik verarbeitet werden kann. So kann etwa ein berührungsloses Bedienfeld oder auch ein Bewegungsmelder am Metallband 102 geschaffen werden.

## Patentansprüche

1. Coil-Coating-Verfahren zur mehrschichtigen Beschichtung eines endlosen Metallbands (3), bei welchem
auf eine Flachseite (4) des Metallbands (3) mithilfe eines Walzenauftrags eine aushärtbare polymere Grundierung (9) zur Ausbildung einer elektrisch isolierenden Grundierungsschicht (10) und
auf diese Grundierungsschicht (10) mithilfe eines Walzenauftrags ein aushärtbarer polymerer Lack (11) zur Ausbildung einer elektrisch isolierenden Lackschicht (12) aufgebracht und gehärtet werden,
wobei zwischen Grundierungsschicht (10) und Lackschicht (12) wenigstens eine elektrische Leiterschicht (15) zumindest bereichsweise aufgedruckt wird,
**dadurch gekennzeichnet, dass**
an die elektrische Leiterschicht (15) zumindest bereichsweise eine elektrisch polarisierbare Schicht (18) aufgebracht wird, wobei elektrische Leiterschicht (15) und elektrisch polarisierbare Schicht (18) nass-in-nass aufgebracht werden.

2. Coil-Coating-Verfahren nach Anspruch 1, **dadurch gekennzeichnet, dass** in der elektrisch polarisierbaren Schicht (18) durch eine Polarisierung eine piezoelektrische und/oder pyroelektrische Eigenschaft ausgebildet wird.

3. Coil-Coating-Verfahren nach Anspruch 1 oder 2, **dadurch gekennzeichnet, dass** als elektrische Leiterschicht (15) PEDOT:PSS und/oder als elektrisch polarisierbare Schicht (18) eine PVDF-Schicht, insbesondere eine P[VDF-TrFE]-Schicht, aufgebracht werden.

4. Coil-Coating-Verfahren nach einem der Ansprüche 1 bis 3, **dadurch gekennzeichnet, dass** die elektrische Leiterschicht (15) und die elektrisch polarisierbare Schicht (18) gleichzeitig gehärtet werden.

5. Coil-Coating-Verfahren nach einem der Ansprüche 1 bis 4, **dadurch gekennzeichnet, dass** an die elektrisch polarisierbare Schicht (18) eine weitere, zweite elektrische Leiterschicht (23) aufgedruckt wird.

6. Coil-Coating-Verfahren nach Anspruch 5, **dadurch gekennzeichnet, dass** die erste und zweite elektrische Leiterschicht (15, 23) elektrisch kontaktiert werden und damit die elektrisch polarisierbare Schicht (18) polarisiert wird.

7. Coil-Coating-Verfahren nach einem der Ansprüche 1 bis 6, **dadurch gekennzeichnet, dass** die elektrische Leiterschicht (15, 23) mithilfe eines Rolle-zu-Rolle-Verfahrens, insbesondere eines Walzenauftrags, aufgedruckt wird.

8. Coil-Coating-Verfahren nach Anspruch 7, **dadurch gekennzeichnet, dass** die elektrische Leiterschicht (15, 23) als Rapport aufgedruckt wird.

9. Coil-Coating-Verfahren nach einem der Ansprüche 1 bis 8, **dadurch gekennzeichnet, dass** auf der Flachseite (4) des Metallbands (3) eine Konversionsschicht (5) erzeugt wird, an der die aushärtbare polymere Grundierung (9) angebracht wird.

10. Coil-Coating-Verfahren nach einem der Ansprüche 1 bis 9, **dadurch gekennzeichnet, dass** die elektrische Leiterschicht (15) an der vorgehärteten, insbesondere zumindest bis über den Gelpunkt vorgehärteten, Grundierungsschicht (10) aufgedruckt wird.

11. Coil-Coating-Verfahren nach einem der Ansprüche 1 bis 10, **dadurch gekennzeichnet, dass** sowohl die Grundierung (9) als auch der Lack (11) chemisch vernetzt werden.

12. Metallband, beschichtet mit Hilfe eines Coil-Coating-Verfahrens nach einem der Ansprüche 1 bis 11, mit einer auf einer Flachseite (4) des Metallbands (3) vorgesehenen elektrisch isolierenden Grundierungsschicht (10), mit einer auf der elektrisch isolierenden Grundierungsschicht (10) vorgesehenen elektrisch isolierenden Lackschicht (12) und mit wenigstens einer zwischen Grundierungsschicht (10) und Lackschicht (12) aufgedruckten, elektrischen Leiterschicht (15), **dadurch gekennzeichnet, dass** das Metallband eine elektrisch polarisierte Schicht (18) aufweist, die an die Leiterschicht (15) über eine sich durch ein Nass-in-nass-Aufbringen dieser beiden Schichten (15, 18) ausbildenden Grenzschicht (41) oder Grenzfläche (41) anschließt.

13. Metallband nach Anspruch 12, **dadurch gekennzeichnet, dass** das Metallband (3) eine zweite, auf der elektrisch polarisierten Schicht (18) vorgesehene, elektrische Leiterschicht (23) aufweist.

14. Metallband nach Anspruch 13, **dadurch gekennzeichnet, dass** die erste und zweite elektrische Leiterschicht (15, 23) und die elektrisch polarisierte Schicht (18) mindestens einen Aktor (32) und/oder einen Sensor (31) am Metallband (3) ausbilden.

15. Metallband nach Anspruch 14, **dadurch gekennzeichnet, dass** Aktor (32) und Sensor (31), miteinander elektrisch verbunden, zur Schwingungskompensation am Metallband (3) zusammenwirken.

16. Metallband nach Anspruch 13, **dadurch gekennzeichnet, dass** die elektrisch polarisierte Schicht (18) pyroelektrisch ist und der Sensor (36) als Infrarotsensor ausgebildet ist.

17. Metallband nach einem der Ansprüche 12 bis 16, **dadurch gekennzeichnet, dass** die elektrische Leiterschicht (15) PEDOT:PSS und die elektrisch polarisierbare Schicht (18) PVDF, insbesondere P[VDF-TrFE], aufweisen.

## Claims

1. A coil coating process for multilayer coating of an endless metal strip (3) in which
a curable polymer primer (9) is applied to a flat side (4) of the metal strip (3) with the aid of a roller application in order to form an electrically insulating primer layer (10) and
a curable polymer varnish (11) is applied to this primer layer (10) with the aid of a roller application and cured in order to form an electrically insulating varnish layer (12),
and at least one electric conductor layer (15) is printed at least in some areas between the primer layer (10) and the varnish layer (12),
**characterized in that**
an electrically polarizable layer (18) is applied to at least some regions of the electric conductor layer (15) and the electric conductor layer (15) and the electrically polarizable layer (18) are applied by means of a wet-in-wet process.

2. The coil coating process according to claim 1, **characterized in that** a piezoelectric and/or pyroelectric property is produced in the electrically polarizable layer (18) by means of a polarization.

3. The coil coating process according to claim 1 or 2, **characterized in that** PEDOT:PSS is applied as the electric conductor layer (15) and/or a PVDF layer - more particularly a P[VDF-TrFE] layer - is applied as an electrically polarizable layer (18).

4. The coil coating process according to one of claims 1 through 3, **characterized in that** the electric conductor layer (15) and the electrically polarizable layer (18) are cured simultaneously.

5. The coil coating process according to one of claims 1 through 4, **characterized in that** another, second electric conductor layer (23) is printed onto the electrically polarizable layer (18).

6. The coil coating process according to claim 5, **characterized in that** the first and second electric conductor layers (15, 23) are electrically contacted and as a result, the electrically polarizable layer (18) is polarized.

7. The coil coating process according to one of claims 1 through 6, **characterized in that** the electric conductor layer (15, 23) is printed with the aid of a roller-to-roller process, in particular a roller application.

8. The coil coating process according to claim 7, **characterized in that** the electric conductor layer (15, 23) is printed in the form of a pattern.

9. The coil coating process according to one of claims 1 through 8, **characterized in that** on the flat side (4) of the metal strip (3), a conversion layer (5) is produced onto which the curable polymer primer (9) is applied.

10. The coil coating process according to one of claims 1 through 9, **characterized in that** the electric conductor layer (15) is printed onto the primer layer (10), which has been pre-cured, more particularly pre-cured at least to above the gel point.

11. The coil coating process according to one of claims 1 through 10, **characterized in that** both the primer (9) and the varnish (11) are chemically cross-linked.

12. A metal strip coated with the aid of a coil coating process according to one of claims 1 through 11, having an electrically insulating primer layer (10) that is provided on a flat side (4) of the metal strip (3), having an electrically insulating varnish layer (12) that is provided on the electrically insulating primer layer (10), and having at least one electric conductor layer (15) that is printed between the primer layer (10) and the varnish layer (12), **characterized in that** the metal strip has an electrically polarized layer (18) that adjoins the conductor layer (15) via a boundary layer (41) or boundary surface (41), which is produced by means of a wet-in-wet application of these two layers (15, 18).

13. The metal strip according to claim 12, **characterized in that** the metal strip (3) has a second electric conductor layer (23) that is provided on the electrically polarized layer (18).

14. The metal strip according to claim 13, **characterized in that** the first and second electric conductor layer (15, 23) and the electrically polarized layer (18) form at least one actuator (32) and/or one sensor (31) on the metal strip (3).

15. The metal strip according to claim 14, **characterized in that** the actuator (32) and the sensor (31), which are electrically connected to each other, cooperate to provide oscillation compensation on the metal strip (3).

16. The metal strip according to claim 13, **characterized in that** the electrically polarized layer (18) is pyroelectric and the sensor (36) is embodied as an infrared sensor.

17. The metal strip according to one of claims 12 through 16, **characterized in that** the electric conductor layer (15) contains PEDOT:PSS and the electrically polarizable layer (18) contains PVDF, more particularly P[VDF-TrFE].

## Revendications

1. Procédé de coil coating pour le revêtement multicouche d'une bande métallique continue (3), dans lequel
un apprêt polymère durcissable (9) destiné à former une couche d'apprêt électriquement isolante (10) est appliqué sur un côté plat (4) de la bande métallique (3) à l'aide d'une application au rouleau et durci, et
un vernis polymère durcissable (11) destiné à former une couche de vernis électriquement isolante (12) est appliqué sur cette couche d'apprêt (10) à l'aide d'une application au rouleau et durci,
au moins une couche conductrice électrique (15) étant imprimée au moins dans certaines zones entre la couche d'apprêt (10) et la couche de vernis (12),
**caractérisé en ce**
**qu'**une couche électriquement polarisable (18) est appliquée sur la couche conductrice électrique (15) au moins dans certaines zones, la couche conductrice électrique (15) et la couche électriquement polarisable (18) étant appliquées humide sur humide.

2. Procédé de coil coating selon la revendication 1, **caractérisé en ce qu'**une propriété piézoélectrique et/ou pyroélectrique est créée dans la couche électriquement polarisable (18) par une polarisation.

3. Procédé de coil coating selon la revendication 1 ou 2, **caractérisé en ce que** du PEDOT:PSS est appliqué comme couche conductrice électrique (15) et/ou une couche de PVDF, en particulier une couche de P[VDF-TrFE], est appliquée comme couche électriquement polarisable (18).

4. Procédé de coil coating selon l'une des revendications 1 à 3, **caractérisé en ce que** la couche conductrice électrique (15) et la couche électriquement polarisable (18) sont durcies simultanément.

5. Procédé de coil coating selon l'une des revendications 1 à 4, **caractérisé en ce qu'**une autre, deuxième couche conductrice électrique (23) est imprimée sur la couche électriquement polarisable (18).

6. Procédé de coil coating selon la revendication 5, **caractérisé en ce que** les première et deuxième couches conductrices électriques (15, 23) sont mises en contact électriquement, polarisant ainsi la couche électriquement polarisable (18).

7. Procédé de coil coating selon l'une des revendications 1 à 6, **caractérisé en ce que** la couche conductrice électrique (15, 23) est imprimée à l'aide d'un procédé rouleau à rouleau, en particulier une application au rouleau.

8. Procédé de coil coating selon la revendication 7, **caractérisé en ce que** la couche conductrice électrique (15, 23) est imprimée sous forme de rapport.

9. Procédé de coil coating selon l'une des revendications 1 à 8, **caractérisé en ce qu'**une couche de conversion (5), sur laquelle l'apprêt polymère durcissable (9) est appliqué, est produite sur le côté plat (4) de la bande métallique (3).

10. Procédé de coil coating selon l'une des revendications 1 à 9, **caractérisé en ce que** la couche conductrice électrique (15) est imprimée sur la couche d'apprêt (10) prédurcie, en particulier prédurcie au moins au-dessus du point de gélification.

11. Procédé de coil coating selon l'une des revendications 1 à 10, **caractérisé en ce que** tant l'apprêt (9) que le vernis (11) sont chimiquement réticulés.

12. Bande métallique revêtue au moyen d'un procédé de coil coating selon l'une des revendications 1 à 11, comportant une couche d'apprêt électriquement isolante (10) prévue sur un côté plat (4) de la bande métallique (3), une couche de vernis électriquement isolante (12) prévue sur la couche d'apprêt électriquement isolante (10) et au moins une couche conductrice électrique (15) imprimée entre la couche d'apprêt (10) et la couche de vernis (12), **caractérisée en ce que** la bande métallique présente une couche électriquement polarisée (18) qui fait suite à la couche conductrice (15) par l'intermédiaire d'une couche limite (41) ou d'une surface limite (41) formée par une application humide sur humide de ces deux couches (15, 18).

13. Bande métallique selon la revendication 12, **caractérisée en ce que** la bande métallique (3) présente une deuxième couche conductrice électrique (23) prévue sur la couche électriquement polarisée (18).

14. Bande métallique selon la revendication 13, **caractérisée en ce que** les première et deuxième couches conductrices électriques (15, 23) et la couche électriquement polarisée (18) forment au moins un actionneur (32) et/ou un capteur (31) sur la bande métallique (3).

15. Bande métallique selon la revendication 14, **caractérisée en ce que** l'actionneur (32) et le capteur (31), reliés électriquement l'un à l'autre, coopèrent pour compenser les vibrations sur la bande métallique (3).

16. Bande métallique selon la revendication 13, **caractérisée en ce que** la couche électriquement polarisée (18) est pyroélectrique et le capteur (36) est conçu comme un capteur infrarouge.

17. Bande métallique selon l'une des revendications 12 à 16, **caractérisée en ce que** la couche conductrice électrique (15) présente du PEDOT:PSS et la couche électriquement polarisable (18) du PVDF, en particulier du P[VDF-TrFE].
